Europäisches Patentamt

(19) European Patent Office

Office européen des brevets

(11) Publication number: **0 164 890**
**B1**

(12) **EUROPEAN PATENT SPECIFICATION**

(45) Date of publication of patent specification: **07.12.88**

(51) Int. Cl.⁴: **G 01 R 31/36,** H 02 J 7/10, G 06 F 1/00

(21) Application number: **85303246.4**

(22) Date of filing: **08.05.85**

(54) **Battery-powered computing apparatus including a battery charge level indicating arrangement.**

(30) Priority: **08.05.84 US 608317**

(43) Date of publication of application:
**18.12.85 Bulletin 85/51**

(45) Publication of the grant of the patent:
**07.12.88 Bulletin 88/49**

(84) Designated Contracting States:
**DE FR GB IT**

(56) References cited:
**EP-A-0 074 444**
**CH-A- 648 936**
**US-A-4 387 334**
**US-A-4 455 523**

**FUNKSCHAU, vol. 45, no. 6, 16th March 1973, pages 204-206; D. RÖSNER: "Batterie-Anzeige für Taschenrechner"**

(73) Proprietor: **Hewlett-Packard Company Mail Stop 20 B-O 3000 Hanover Street Palo Alto California 94304 (US)**

(72) Inventor: **Eaton, John Thomas 3226 N.E. Lancaster Drive Corvallis Oregon 97330 (US)**

(74) Representative: **Squibbs, Robert Francis Hewlett-Packard Limited Nine Mile Ride Wokingham Berkshire RG11 3LL (GB)**

Courier Press, Leamington Spa, England.

## Description

The present invention relates to battery-powered computing apparatus including a battery charge level indicating arrangement.

As is well known, many computing systems such·as portable calculators and portable computers require an internal battery in order to operate independently from AC lines. The eventual discharge of the internal battery can cause problems for a computer system operator if sufficient warning of power loss is not given.

Traditionally, battery-powered computer systems have only provided the user with a low battery indicator which directly monitors the battery voltage and informs the user when the voltage level of the battery falls below a predetermined value (see, for example, British Patent No. GB—A—1,363,175). This provides a warning to the user of imminent power loss, but does not allow for longer range anticiptation of power loss.

Another method for monitoring battery discharge is for the user to set a timer immediately upon charging the battery. By referring to the timer the user can determine how long the computer system has been running since the battery was last recharged. This method unfortunately has many drawbacks not the least of which is that no account is taken of the differing effects on battery charge level of ·different types of operation in which the computing system may be involved.

It is also known to provide more complex battery monitoring systems. Ony such system is described in European Patent Application No. EP—A—0,074,444 and in this system charging of the battery is controlled by a microprocessor which is fed with the outputs from a number of sensors set to monitor respective battery operating variables such as current drain and temperature. While such systems can be very effective, their cost and complexity makes them unsuitable for use in portable calculators and portable computers.

It is an object of the present invention to provide a relatively simple battery charge level indicator which can provide the operator of the computing system with a reasonably accurate indication of the state of the battery but does not require detailed measurements of the battery's operating parameters.

In accordance with the present invention, bhis object is achieved by the provision of battery-powered computing apparatus including a battery charge level indicating arrangement characterized in that said arrangement comprises calculating means for computing a value related to the level of charge of the battery, the calculating means being operative to distinguish between predetermined operations involving the apparatus and being arranged, in computing said value, to take into account the respective effect on battery charge level of each said operation actually undertaken by the apparatus by utilising a predetermined estimate of that effect to update a previous computation of said value (FUEL), and display means for displaying said value or a quantity dependent thereon.

Since the value computed by the battery charge level indicating arrangement reflects the differing effect on battery charge state of different operations performed by the computing apparatus, the indication of battery charge level provided by the computed value is more accurate than that achievable by a simple timer. Furthermore, where one of said predetermined operations is a recharging operation, the problem of having to reset the value whenever the battery is recharged is avoided as is the problem of deciding a reset point where the battery is only partially recharged (both these problems are, of course, inherent in the aforementioned timers).

The number of operations distinguished by the calculating means depends on the required refinement of the arrangement. Advantageously, the predetermined operations include a dormant operation, a wait operation, a computing operation, one or more interface operations (for example, RS232 interface, modem link) and a recharging operation.

In a preferred embodiment of the indicating arrangement, the calculating means includes a memory for storing said value, the calculating means being arranged at intervals to compute an updated value by adjusting the stored value by an amount corresponding to the change in battery charge caused since the last update as a result of the current said operation or operations involving the apparatus. Advantageously, during each update, an adjustment to said stored value is made for each said operation that is current, each said adjustment having a magnitude dependent on a predetermined estimate of the battery current caused by the corresponding operation and on the time interval since the last update.

It will be appreciated that the computing apparatus may either be one intended to be powered only by a battery or one which has the additional capability of being mains powered; in this latter case, the calculating means is, of course, arranged to distinguish between battery and mains operation of the apparatus.

The said value computed by the calculating means may be a direct measure of the battery charge state (for example, per centage charge remaining) or some other related measure (such as remaining life based on a projected average charge depletion rate). Furthermore, the display means may display said value direct or else a related quantity, such as an analog representative of said value (the value computed by the calculating means will generally be numeric although this may not always be the case as the calculating means could in theory be of analog form).

There now follows a detailed description which is to be read with reference to the accompanying drawings of a computing system provided with a battery-charge level indicating arrangement, it is to be understood that the computing system and indicating arrangement has been selected for description to illustrate the invention by way of example and not by way of limitation.

In the drawings:

Figure 1 is a block diagram of the computing system including the battery charge level indicating arrangement;

Figure 2 is a flowchart illustrating the operation of the battery charge level indicating arrangement.

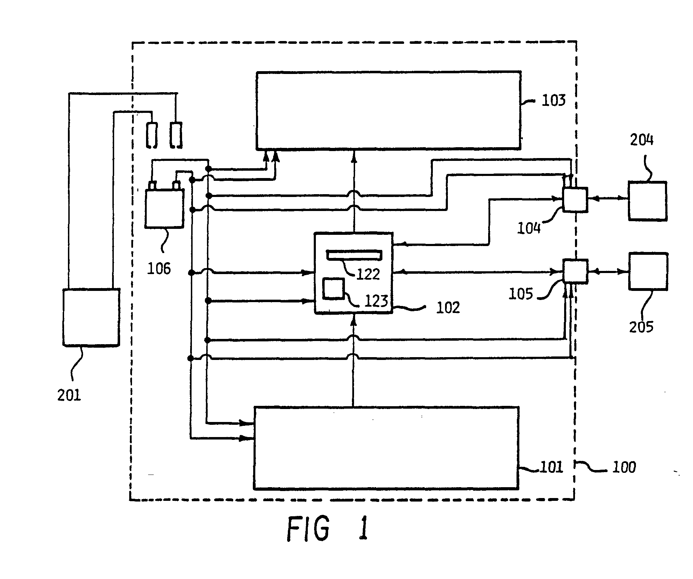

In Figure 1, a microcomputer 102 within a computing system 100 calculates the charge within a battery 106. The value (FUEL) representing the current charge within battery 106 is stored by the microcomputer 102 within a memory register 122. The value FUEL in the register 122 is continually updated to accurately represent the current charge within the battery 102.

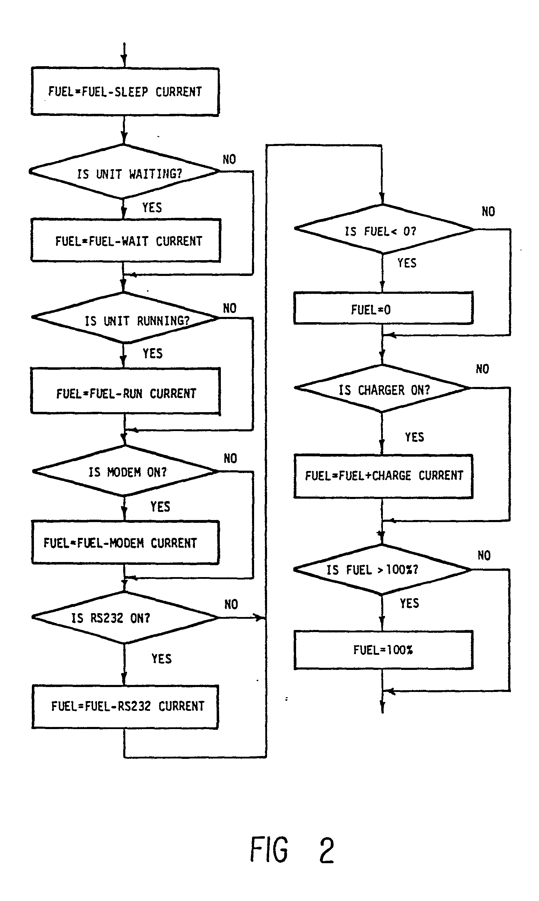

For instance, in the preferred embodiment, every 128 milliseconds (ms) the microcomputer 102 runs a monitor program 123—a flowchart of the monitor program is shown in Figure 2. The monitor program 123 first subtracts from FUEL a value representing the minimum amount of charge consumed by computing system 100. This minimum charge may be calculated by multiplying the current used by computing system 100 when it is inactive (SLEEP) times 128 ms. In the flowchart of Figure 2, the operation of depleting FUEL by said minimum charge is represented by the operation FUEL=FUEL−SLEEP CURRENT.

The monitor program 123 then takes into account the amount of additional charge consumed by the computing system 100 for its other activities. A value representing this additional charge is subtracted from FUEL. If computing system 100 is active but in a wait mode, the additional charge is calculated based on the current (WAIT CURRENT) used by computing system 100 in wait mode. If computing system is performing an operation, the additional charge is calculated based on the current (RUN CURRENT) used by computing system 100 to perform the operation.

The monitor program 123 also may take into account the amount of charge consumed by the computing system 100 in interfacing with other computing systems. For instance, if a modem interface 104 is interacting with a modem 204, the monitor program 123 subtracts from FUEL a value representing an amount of charge based on the current (MODEM CURRENT) used by this interaction. If a RS232 cable interface 105 is interacting with another compouting system 205, the monitor program 123 subtracts from FUEL a value representing an amount of charge based on the current (RS232 CURRENT) used by this interaction.

Since the battery 106 cannot store a negative charge, the monitor program 123 will not store a value of FUEL less than 0. Additionally, if a charger 201 is charging battery 106, the monitor program will add to FUEL a value based on the average current (CHARGE CURRENT) the battery 106 draws when it is charging. Finally, if the battery is fully charged (FUEL=100%), additional charging will not result in additional charge being stored ion the battery 106, so the monitor program 123 will not allow the value of FUEL to be over 100%.

An operator may obtain the current value of FUEL by entering an appropriate command on a keyboard 101. The current value of FUEL may then be presented on a display 103. Additionally, if desired, the computing system 100 may present the current value of FUEL as the end of each command given by the operator to the computing system.

Initial determination of when the battery 106 is fully charged (FUEL=100%) can be utilized throughout the life of the battery 106, or can be adjusted by the microcomputer 100 to compensate for performance degradation resulting from ageing of the battery 106.

From the foregoing, it can be seen that the battery charge level indicating arrangement described and illustrated above serves to compute and store a value which represents the amount of charge within the battery of the computing system. The charge value is varied to take into account the amount of charge consumed by computer operations, and the amount of charge replenished by a battery recharger. The charge value is readily accessible by a computer operator, thus providing him with accurate information concerning the charge within the battery and allowing the operator to more accurately estimate the amount of operations which may be done before power loss occurs.

**Claims**

1. Battery-powered computing apparatus (100) including a battery charge level indicating arrangement characterized in that said arrangement comprises:

calculating means (102) for computing a value (FUEL) related to the level of charge of the battery (106), the calculating means (102) being operative to distinguish between predetermined operations involving the apparatus (100) and being arranged, in computing said value (FUEL), to take into account the respective effect on battery charge level of each said operation actually undertaken by the apparatus (100) by utilizing a predetermined estimate of that effect to update a previous computation of said value (FUEL), and

display means (103) for displaying said value (FUEL) or a quantity dependent thereon.

2. Computing apparatus according to claim 1, wherein the calculating means (102) includes a memory (102) for storing said value (FUEL), the calculating means (102) being arranged at time intervals to compute an updated value of said value (FUEL) by adjusting the stored value (FUEL) by an amount corresponding to the change in battery charge caused since the last update as a result of the current said operation or operations involving the apparatus (100).

3. Computing apparatus according to claim 2, wherein during each update, an adjustment to said stored value (FUEL) is made for each said operation that is current, each said adjustment having a magnitude dependent on a predetermined estimate of the battery current caused by the corresponding operation and on the time interval since the last update.

4. Computing apparatus according to claim 2 or claim 3, wherein the said predetermined operations include one or more first operations that result in a reduction in the battery charge, and a second, battery-recharging operation, the calculating means (102) being arranged to adjust said value (FUEL) in one direction when taking account of the or each first operation undertaken by the apparatus (100), and in the opposite direction when taking account of the said second operation.

5. Computing apparatus according to any one of the preceding claims, wherein the said predetermined operations include a computing operation.

6. Computing apparatus according to any one of the preceding claims wherein the said predetermined operations include a non-computing operation.

7. Computing apparatus according to claim 6, wherein said non-computing operation is an operation that increases the charge in the battery.

8. Computing apparatus according to claim 6, wherein said non-computing operation is an operation that interfaces the apparatus (100) with another system.

9. Computing apparatus according to any one of the preceding claims, wherein the calculating means (102), in determining said value, is arranged to take into account changes in the performance of the battery (106) due to ageing.

**Patentansprüche**

1. Batteriebetriebenes Rechengerät (100) mit einer Batterie-Ladungszustands-Anzeigeeinrichtung, gekennzeichnet durch:

eine Recheneinrichtung (102) zum Berechnen eines auf den Ladungszustand der Batterie (106) bezogenen Wertes (FUEL), wobei die Recheneinrichtung (102) zwischen vorbestimmten Operationen, an denen das Gerät (100) besteiligt ist, unterscheiden kann und so ausgelegt ist, daß sie die jeweilige Wirkung der einzelnen vom Gerät (100) tatsächlich ausgeführten Operationen auf den Ladungszustand in der Weise berücksichtigt, daß sie einen zuvor ermittelten Wert dieser Wirkung zur Fortschreibung der vorherigen Berechnung des Wertes (FUEL) verwendet, und

Anzeigemittel (103) zum Anzeigen des Wertes (FUEL) oder einer davon abhängigen Menge.

2. Rechengerät nach Anspruch 1, dadurch gekennzeichnet, daß die Recheneinrichtung (102) einen Speicher (102) für den Wert (FUEL) besitzt, wobei die Recheneinrichtung (102) so ausgelegt ist, daß sie in zeitlichen Abständen jeweils einen fortgeschriebenen Wert des Wertes (FUEL) in der Weise errechnet, daß sie den gespeicherten Wert (FUEL) um einen Wert berichtigt, der der seit der letzten Fortschreibung infolge des Stromes der Operationen, an der das Gerät (100) beteiligt war, eingetretenen Veränderung der Batterieladung entspricht.

3. Rechengerät nach Anspruch 2, dadurch gekennzeichnet, daß während der Fortschreibung für jede laufende Operation eine Berichtigung an dem gespeicherten Wert (FUEL) vorgenommen wird, wobei der Betrag der Bereichtigung sich nach einer vorherigen Ermittlung des durch die betreffende Operation verursachten Batteriestromes und nach dem Zeitabstand seit der vorausgegangenen Fortschreibung bestimmt.

4. Rechengerät nach Anspruch 2 oder 3, dadurch gekennzeichnet, daß die vorbestimmten Operationen eine oder mehrere erste, zu einer Absenkung der Batterieladung führende Operationen und zweite, eine Wideraufladung der Batterie bewirkende Operationen umfassen, wobei die Recheneinrichtung (102) so ausgelegt ist, daß der Wert (FUEL) bei Ausführung einer der ersten Operationen durch das Gerät (102) in einer Richtung und bei einer der zweiten Operationen in der entgegengesetzten Richtung berichtigt wird.

5. Rechengerät nach einem der vorherigen Ansprüche, dadurch gekennzeichnet, daß die vorbestimmten Operationen eine Rechenoperation umfassen.

6. Rechengerät nach einem der vorherigen Ansprüche, dadurch gekennzeichnet, daß die vorbestimmten Operationen eine keine Rechenoperation darstellende Operation umfassen.

7. Rechengerät nach Anspruch 6, dadurch gekennzeichnet, daß es sich bei der keine Rechenoperation darstellenden Operation um eine solche handelt, die die Batterieladung erhöht.

8. Rechengerät nach Anspruch 6, dadurch gekennzeichnet, daß es sich bei der keine Rechenoperation darstellenden Operation um eine solche handelt, die das Gerät (100) mit einem anderen System verbindet.

9. Rechengerät nach einem der vorherigen Ansprüche, dadurch gekennzeichnet, daß die Recheneinrichtung (102) bei der Ermittlung des besagten Wertes alterungsbedingte Änderungen der Leistung der Batterie (106) berücksichtigt.

**Revendications**

1. Calculateur alimenté par accumulateur (100) comprenant un dispostiif pour indiquer le niveau de charge de l'accumulateur caractérisé en ce que ledit dispositif comprend:

un moyen de calcul (102) servant à calculer une valeur (COMBUSTIBLE) se rapportant au niveau de charge de l'accumulateur (106), le moyen de calcul (102) étant capable de différencier des fonctionnements prédéterminés mettant en jeu le calculateur (100) et étant conçu dans le calcul de ladite valeur (COMBUSTIBLE), pour prendre en considération l'incidence respective sur le niveau de charge de l'accumulateur de chacun desdits fonctionnements effectivement accompli par le calculateur (100) en utilisant une évaluation prédéterminée de cette incidence pour effectuer la mise à jour d'un calcul antérieur de ladite valeur (COMBUSTIBLE), et

un moyen d'affichage (103) servant à afficher ladite valeur (COMBUSTIBLE) ou une quantité qui s'y rapporte.

2. Calculateur selon la revendication 1, dans lequel le moyen de calcul (102) comprend une mémoire (102) servant au stockage de ladite valeur (COMBUSTIBLE), le moyen de calcul (102) étant agencé pour calculer à des intervalles de temps une valeur mise à jour de ladite valeur (COMBUSTIBLE) en ajustant la valeur stockée (COMBUSTIBLE) selon une quantité correspondant à la modification intervenue dans la charge de l'accumulateur depuis la dernière mise à pour par l'effet dudit fonctionnement en cours ou desdits fonctionnements mettant en jeu le calculateur (100).

3. Calculateur selon la revendication 2, dans lequel pendant chaque mise à jour, un ajustement de ladite valeur stockée (COMBUSTIBLE) est réalisé pour chacun desdits fonctionnements qui est en cours, chacun desdits adjustements ayant une ampleur qui est fonction de l'évaluation prédéterminée du courant de l'accumulateur utilisé par le fonctionnement correspondant et au cours de l'intervalle de temps écoulé depuis la dernière mise à jour.

4. Calculateur selon la revendication 2 ou la revendication 3, dans lequel lesdits fonctionnements prédéterminés comprennent un premier fonctionnement au moins ayant pour effet une diminution de la charge de l'accumulateur, et un second qui est un fonctionnement de rechargement de l'accumulateur, le moyen de calcul (102) étant agencé pour ajuster ladite valeur (COMBUSTIBLE) dans un sens au moment de la prise en compte de chaque premier fonctionnement, accompli par le calculateur (100), et dans le sens contraire au moment de la prise en compte dudit second fonctionnement.

5. Calculateur selon l'une quelconque des revendications précédentes, dans lequel lesdits fonctionnements prédéterminés comprennent un fonctionnement de calcul.

6. Calculateur selon l'une quelconque des revendications précédentes, dans lequel lesdits fonctionnements prédéterminés comprennent un fonctionnement qui n'est pas de calcul.

7. Calculateur selon la revendication 6 dans lequel ledit fonctionnement de non calcul est un fonctionnement qui augmente la charge de l'accumulateur.

8. Calculateur selon la revendication 6, dans lequel ledit fonctionnement de non calcul est un fonctionnement faisant communiquer le calculateur (100) avec un autre système.

9. Calculateur selon l'une quelcoqnue des revendications précédentes, dans lequel le moyen de calcul (102), dans la détermination de ladite valeur, est conçu pour prendre en considération les modifications de caractéristiques de l'accumulateur (106) dûes au vieillissement.

FIG 1

FIG 2